# EUROPEAN PATENT SPECIFICATION

(11) **EP 3 239 053 B1**
(45) Date of publication and mention of the grant of the patent: **31.10.2018**
(21) Application number: 17168276.8
(22) Date of filing: 26.04.2017
(51) Int. Cl.: B64D 43/00, G06F 3/01, G06F 3/0488, G06F 3/0484

(54) **CENTER PEDESTAL DISPLAY**
ZENTRALE SOCKELANZEIGE
ÉCRAN À SOCLE CENTRAL

(30) Priority: 27.04.2016 US 201662328582 P; 25.04.2017 US 201715497113
(43) Date of publication of application: 01.11.2017
(73) Proprietor: Bell Helicopter Textron Inc., Fort Worth, TX 76101 (US)
(72) Inventor: KIHARA, Steven W, North Richland Hills, TX Texas 78162 (US); ERWIN, Jeffrey W, Chico, TX Texas 76431 (US); CHAVEZ, Jeremy R, Colleyville, TX Texas 76034 (US)
(74) Representative: Barker Brettell LLP

(56) References cited:
- EP-A2- 2 587 350
- US-A1- 2012 189 368
- US-A1- 2013 234 949
- US-A1- 2015 143 276
- US-A1- 2017 003 837

## Description

### BACKGROUND

The cockpits of modern aircraft have evolved from exclusive use of mechanical and electromechanical gauges and switches to use of electronic displays and switches for primary flight instruments and control of aircraft systems. These displays include multi-function displays (MFDs), which typically use line-address and bezel keys arrayed around the screen to access modes for data entry or activate functions.

EP 2587350 discloses a method of operating an aircraft, which has a cockpit with a flight deck having at least one touch screen display, which includes sensing an object, touching on the at least one touch screen display to define an input touch and determining whether the input touch on the at least one touch screen display is invalid.

US 2013/234949 discloses a keyboard, which includes rows of keys defining a keyboard axis and side borders of the keyboard, the keyboard axis disposed mediates the side borders of the keyboard, the rows of keys disposed in series with each other along the keyboard axis, and the keyboard axis being disposed at an acute or obtuse angle relative to a user of the keyboard and being generally aligned along a length of an arm of the user holding the keyboard.

US 2015/143276 discloses a method for controlling a control region on a display screen of a computerized system. The method includes obtaining data from a touchpad. The data is associated with a position of a portion of the hand of a user when the user operates the touchpad. The method includes transmitting the data from the touchpad to the computerized device and analyzing the data in accordance with a model of a human hand. In certain embodiments, the method includes identifying different sets of virtual keys to be associated with the different fingers of the user's hand and generating a control region comprising the sets of virtual keys. In some embodiments, the method includes displaying the control region in a position on the display screen in accordance with a position of one or more fingers of the user's hand on the touchpad.

US 2012/189368 discloses a typing apparatus. The typing apparatus comprises a plurality of overloaded keys in a key layout. The plurality of overloaded keys comprises at least three injectively overloaded keys disposed in a first row of keys. At least one first injectively overloaded key is injectively overloaded with a first set of characters assigned to a first finger in a represented non-overloaded keyboard. The plurality of overloaded keys also comprises at least one second injectively overloaded key disposed outside the first row of keys. The at least one second injectively overloaded key is injectively overloaded with a second set of characters assigned to the first finger in the represented non-overloaded keyboard.

### BRIEF DESCRIPTION OF THE DRAWINGS

Figure 1 is an oblique see-through view of a forward portion of an aircraft.
Figure 2 is a rear view of an instrument panel and center pedestal assembly of the aircraft of Figure 1.
Figure 3 is a normal view of a central display unit of the aircraft of Figure 1.
Figure 4 is a normal view of a keyboard of the aircraft of Figure 1.
Figure 5 is an oblique see-through view of a forward portion of an aircraft.
Figure 6 is a rear view of an instrument panel and center pedestal assembly of the aircraft of Figure 5, the center pedestal being configured according to this disclosure.
Figure 7 is a normal view of a first embodiment of a graphical display mode of the center pedestal of Figure 6 and according to this disclosure.
Figure 8 is a normal view of another embodiment of a graphical display mode of the center pedestal of Figure 6 and according to this disclosure.
Figure 9 is a normal view of another embodiment of a graphical display mode of the center pedestal of Figure 6 and according to this disclosure.
Figure 10 is a normal view of another embodiment of a graphical display mode of the center pedestal of Figure 6 and according to this disclosure.
Figure 11 is a normal view of another embodiment of a graphical display mode of the center pedestal of Figure 6 and according to this disclosure.
Figure 12 is a normal view of another embodiment of a graphical display mode of the center pedestal of Figure 6 and according to this disclosure.
Figure 13 is a simplified representation of a general-purpose processor (e.g. electronic controller or computer) system suitable for implementing the embodiments of this disclosure.

### DETAILED DESCRIPTION

In this disclosure, reference may be made to the spatial relationships between various components and to the spatial orientation of various aspects of components as the devices are depicted in the attached drawings. However, as will be recognized by those skilled in the art after a complete reading of the present disclosure, the devices, members, apparatuses, etc. described herein may be positioned in any desired orientation. Thus, the use of terms such as "above," "below," "upper," "lower," or other like terms to describe a spatial relationship between various components or to describe the spatial orientation of aspects of such components should be understood to describe a relative relationship between the components or a spatial orientation of aspects of such components, respectively, as the device described herein may be oriented in any desired direction.

Aircraft system interfaces, such as those for tuning radio frequencies, accessing system diagnostic displays, inputting navigation information, accessing the flight director, etc., have typically been physical knobs, buttons, and switches affixed to the airframe on a forward instrument panel or center pedestal and oriented parallel to the aircraft centerline. Touchscreens are becoming more commonplace in aircraft, but these are typically constrained to being small screens that are also oriented parallel to the aircraft centerline.

Most flight-crew seats are installed in a fixed orientation relative to an aircraft centerline so that the crewmember is facing forward, and this means that system-interface switches, input devices, and displays are oriented parallel to the flight crew. Especially for the interfaces on the center pedestal, this parallel orientation results in the actual or perceived need of the crewmember to rotate the head, bend the neck, bend the torso, or use a combination of these to interact with the interfaces. Crewmembers may experience negative effects ranging from temporary discomfort during flight to permanent physical damage due to occasionally maintaining these contorted positions during thousands of flight hours. In addition, another problem encountered with the use of parallel-to-centerline pedestal interfaces is the colliding of the helmets of crewmembers, which is referred to as "head knocking." This can occur when a crewmember on one side of the pedestal is interacting with a pedestal-mounted interface and the crewmember on the other side of the pedestal leans in to view the activity, which may be done to, for example, double-check an input value, read a display, or satisfy curiosity.

Replacing traditional pedestal interfaces with a full touchscreen devoid of physical switches, knobs, or keys allows for graphically representing interfaces, and instructions in the software programs can provide for selective rotation of the graphical representations of virtual input keys and switches and related information to an orientation that is more ergonomic for the flight crew. These interfaces are preferably aligned to approximately perpendicular with the head and upper torso as the crewmember naturally turns to interact with the interfaces on the pedestal.

Additionally, the pedestal touchscreen has the ability to provide dual split-screen information for simultaneous access for both crewmembers, with full-screen display for either to access any available configurations.

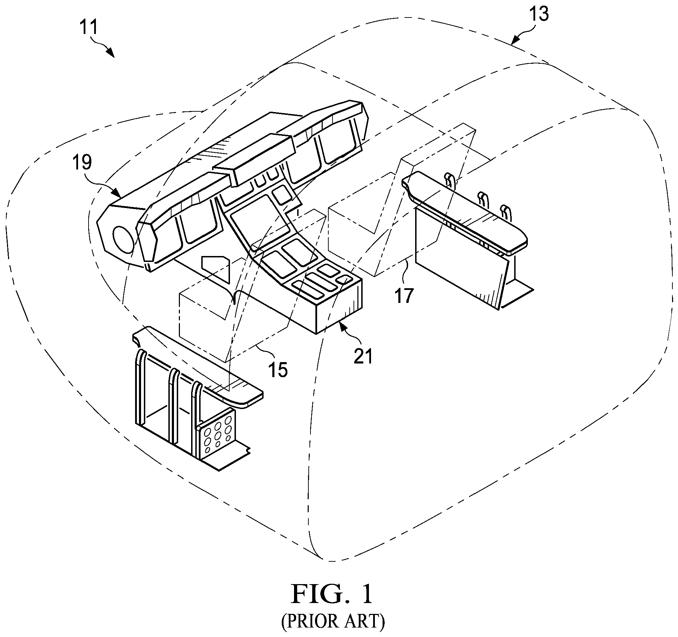

Figure 1 illustrates the forward portion of an aircraft 11, cockpit 13 being located in the forward portion. Cockpit 13 is the flight deck and the location of primary controls for aircraft systems, and two crewmembers sit in a side-by-side arrangement in seats 15, 17. A pilot-in-command is typically located in left seat 15 for fixed-wing aircraft and right seat 17 for rotary-wing aircraft, and a copilot or instructor pilot is typically located in right seat 17 for fixed-wing aircraft and left seat 15 for rotary-wing aircraft. Aircraft 11 is shown equipped with prior-art instrument panel 19 and prior-art center pedestal 21.

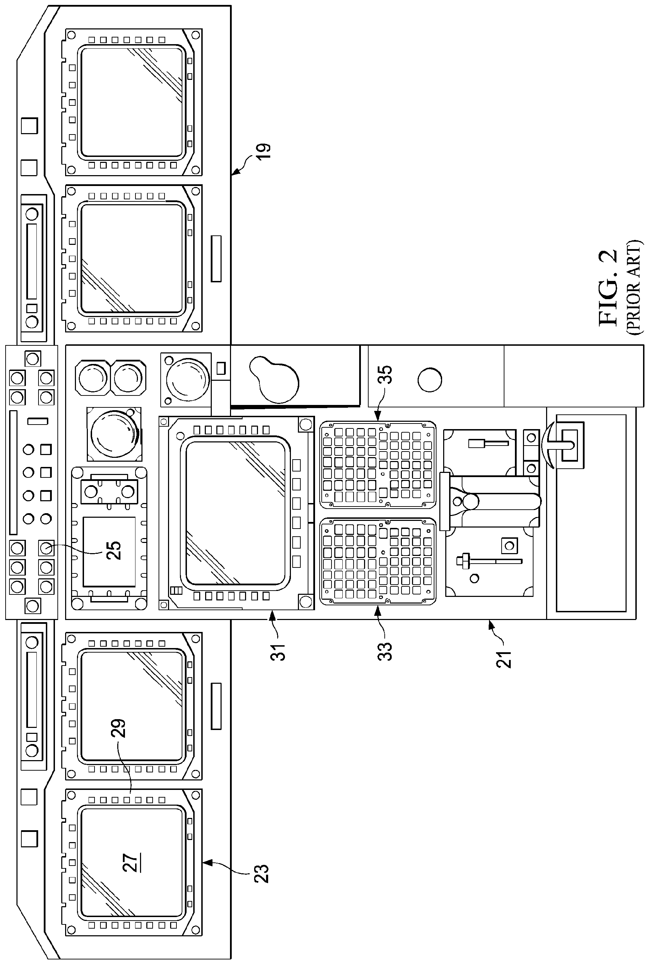

Figures 2 through 4 illustrate panel 19, pedestal 21, and components thereof. Panel 19 comprises a pair of MFDs 23 located in front of each crewmember station, as well as various switch panels 25 located across an upper portion of panel 19. MFDs 23 have an LED screen 27 surrounded by function keys 29. Pedestal 21 comprises a central display unit (CDU) 31, a pair of adjacent CDU keyboards 33, 35 (one for each crewmember), and various switches and gauges.

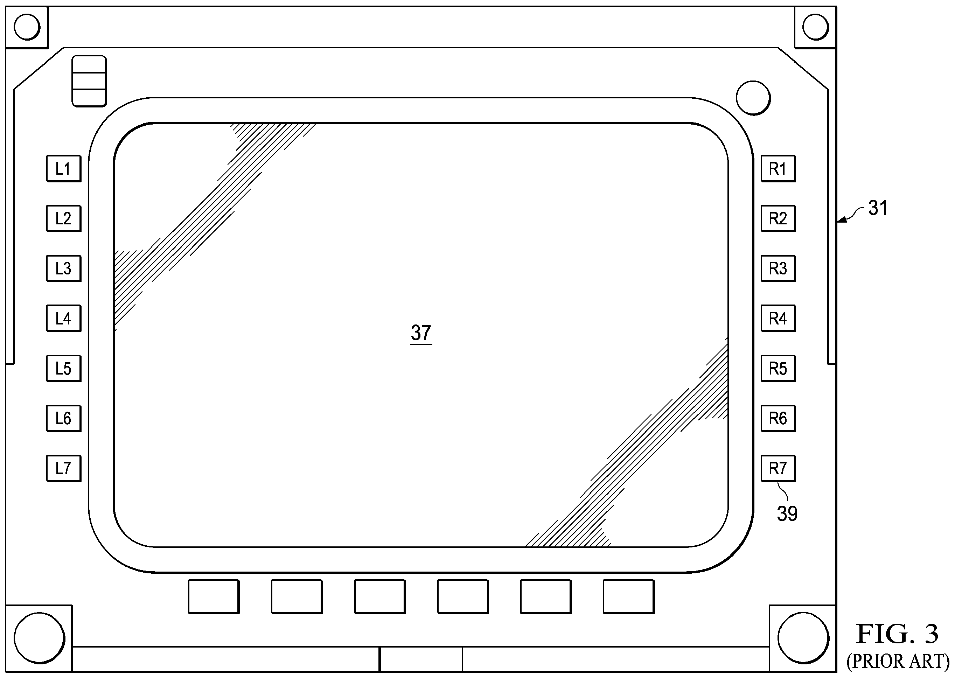

Referring to Figure 3, CDU 31, like MFDs 23, has an LED screen 37 surrounded by keys 39, which are typically line-address or other bezel keys for operating and interfacing with CDU 31. Screen 37 is in electronic communication with a general-purpose processor system used to generate messages, interactive text, and other graphical representations for display on CDU 31, allowing crewmembers to interface with and control various aircraft systems, as described above.

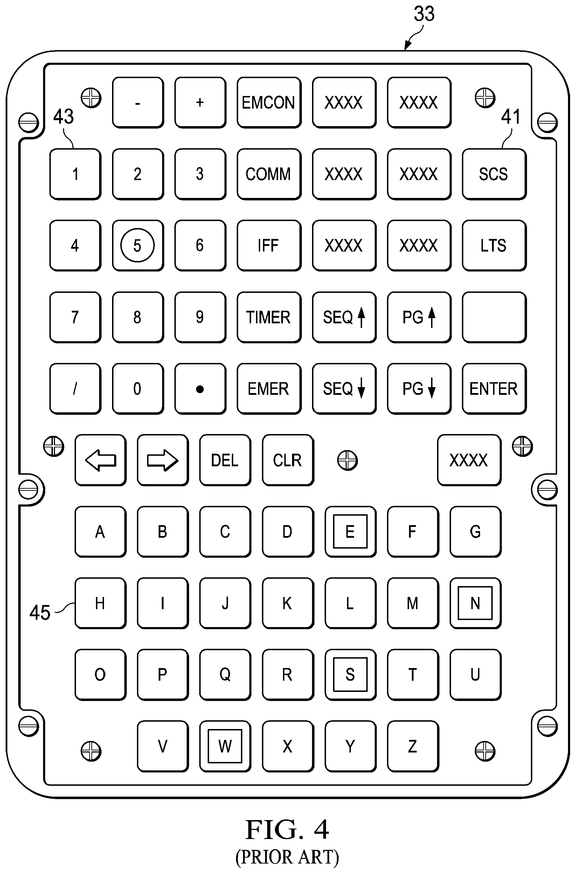

Referring to Figure 4, CDU keyboard 33 comprises a variety of function keys 41, number pad keys 43, and alphabet keys 45, keyboard 35 having a similar configuration and function to that of keyboard 33. Keys 41, 43, 45 are used by crewmembers to interact with CDU 31, such as for inputting data or making selections in response to text or other representations displayed on screen 37 of CDU 31. For example, a crewmember may press a key 39 on CDU 31, which causes to be displayed on screen 37 text related to a particular aircraft system and mode of input. One crewmember or the other may then use keyboard 33 or 35 to enter data or make a selection from options available in that mode.

As clearly visible in Figure 2, CDU 31 and keyboards 33, 35 are oriented as parallel to the centerline of aircraft 11, encouraging or requiring crewmembers to maintain awkward positions to interact with keyboards 33, 35, resulting in the negative physical effects mentioned above.

In order to eliminate or reduce the actual or perceived need to lean toward the center pedestal, aircraft 11 may alternatively be equipped with full touchscreen system interfaces according to this disclosure and providing the capability of selective rotation of the displayed graphical elements toward alignment with the crewmember using the interface. In addition, system interfaces according to this disclosure may provide the capability of selective translation of the displayed graphical elements on the touchscreen or between multiple touchscreens.

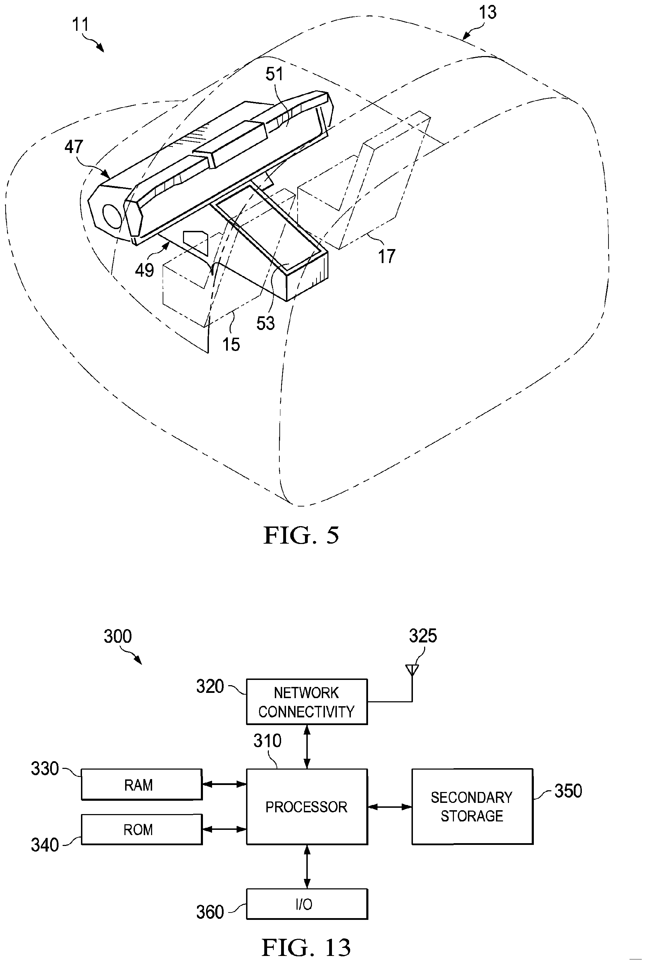

Figure 5 illustrates the forward portion of aircraft 11, with instrument panel 47 extending across the width of cockpit 13, and center pedestal 49 extending rearward from beneath panel 47 and generally along and parallel to the centerline of aircraft 11. Panel 47 has a touchscreen interface 51 that preferably extends for the entire width of panel 47. Interface 51 is discussed herein as a unitary device, though interface 51 may be constructed of multiple individually replaceable panels. As with panel 19 described above, each crewmember has a portion of panel 47 located in front of one of seats 15, 17, allowing the crewmember to interact with the portion of interface 51 located directly forward of the crewmember. Pedestal 49 is located between seats 15, 17, and pedestal 49 has a touchscreen interface 53 that preferably extends across substantially all of the upward facing portion of pedestal 49. As with panel 19 and pedestal 21, described above, touchscreen interfaces 51, 53 are positioned to be within reach of the crewmembers for each crewmember's respective portion of interfaces 51, 53.

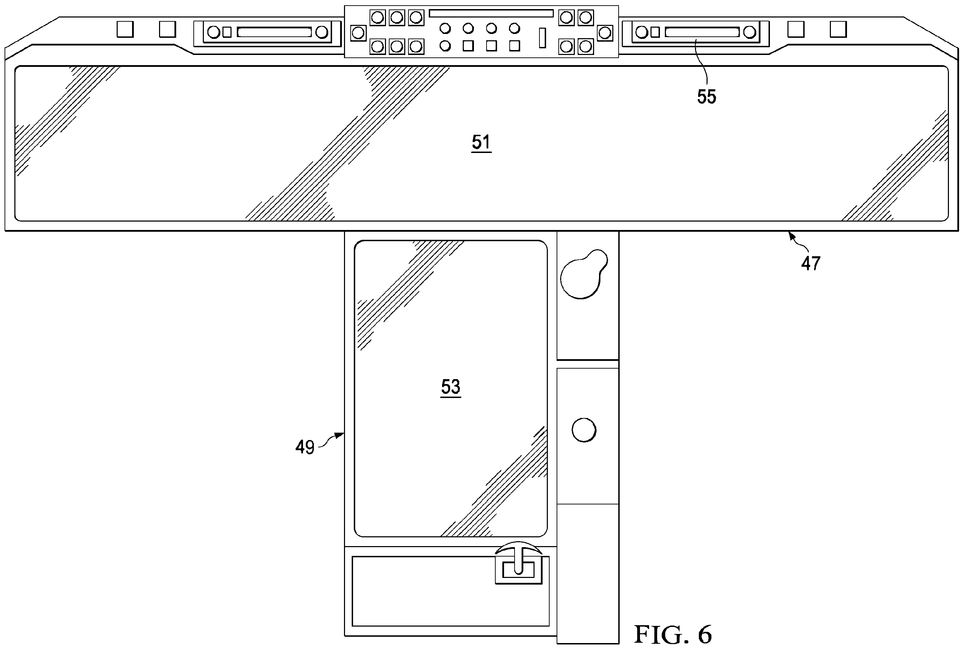

Figure 6 shows panel 47 and pedestal 49 in isolation for ease of viewing. As described above, touchscreen interface 51 preferably extends for the full width of panel 47. Touchscreen interface 53 is located directly below and generally adjacent interface 51, which can provide for an apparent seamless transition between interfaces 51, 53. Instrument panel 47 may optionally comprise physical switches and displays, such as those shown at 55, for various functions. Interfaces 51, 53 are in electronic communication with a general purpose processor system that generates graphical representations for display on interfaces 51, 53 and receives input from crewmembers touching interfaces 51, 53.

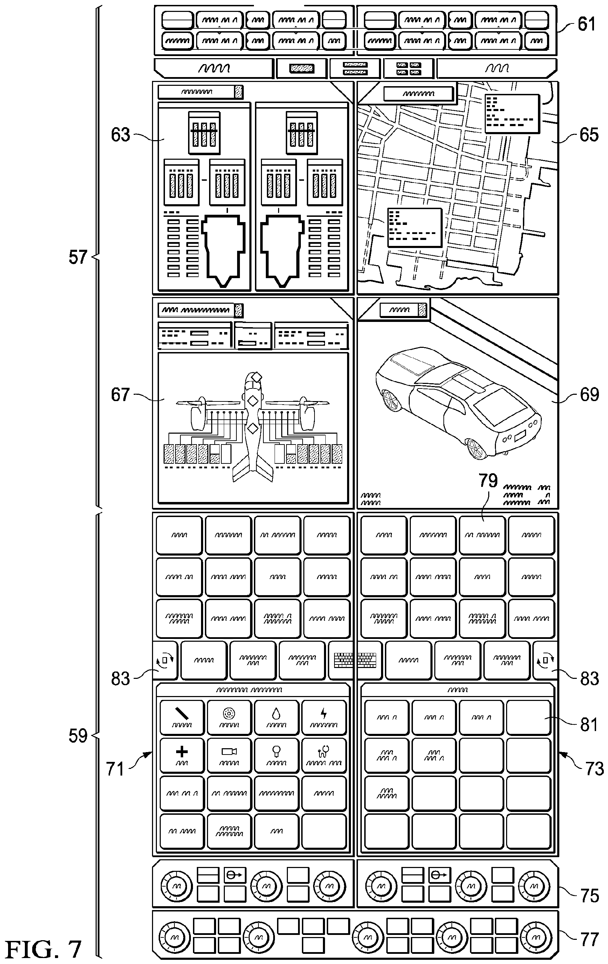

Figures 7 through 12 illustrate embodiments of graphical display modes for use with touchscreen interfaces 51, 53. In each example embodiment, two sections of graphical displays are shown, with a panel display 57 shown above a pedestal display 59. In the embodiments shown, each panel display 57 is presented to the crewmembers on a central portion of touchscreen interface 51 of panel 47, whereas each pedestal display 59 is presented to the crewmembers on the whole of touchscreen interface 53 of pedestal 49. Though panel display 57 is shown as identical for each embodiment, display 57 can be configured to represent other information, preferably as selected by the crewmembers.

Figure 7 illustrates an embodiment of a graphical display mode for use with interfaces 51, 53. Panel display 57 is shown representing information related to systems of aircraft 11 in areas 61, 63, 65, 67, 69, and these areas may be configured as shown or in alternative configurations. As shown, areas 61, 63, 67 represent the status of systems of aircraft 11, whereas areas 65, 69 represent data illustrating environments external to aircraft 11. Panel display 57 is the primary means through which crewmembers visually monitor aircraft systems and see results from input at pedestal display 59.

Pedestal display 59 is the primary means through which crewmembers directly interface with the systems of aircraft 11. As shown in Figure 7, display 59 includes graphical representations of virtual input devices, such as arrays of virtual keys and knobs, and these are configured in an orientation parallel to the centerline of aircraft 11 as typically found for physical interfaces of prior-art pedestals. In normal use, display 59 is preferably separated into a left input section 71 and a right input section 73, as well as additional display/input areas 75, 77 located below section 71, 73. Sections 71, 73 comprise graphical representations of virtual function or input keys 79, as well as representations of empty virtual key locations 81. Providing a split pedestal display 59 allows the crewmembers to see and configure their respective sections 71, 73, which may be identical or similar, or each section 71, 73 may have a configuration specific to each crewmember and based on assigned tasks.

In the preferred embodiments, only virtual keys applicable to the selected mode(s) appear, allowing for decluttering of pedestal display 59. For example, if inputting only numbers, only a number pad appears for that crewmember. This is applicable, for example, when inputting a radio frequency or decimal Global Positioning System (GPS) coordinates. However, inputting, for example, a military grid reference system (MGRS) coordinate or other alphanumeric data would preferably show only the keys necessary for that type of input.

The use of a touchscreen on pedestal interface 53 for presenting pedestal display 59 eliminates the requirement for physical input devices, such as physical keyboards, that are affixed to the pedestal and aligned with the centerline of aircraft 11. This allows for any virtual input device, such as, for example, virtual keys, keyboards, number pads and knobs, to be rotated to a more ergonomic orientation relative to the crewmember interfacing with the virtual input device. This allows a crewmember to more easily work on assigned tasks and may reduce the urge for the other crewmember to twist or lean toward the pedestal to watch data input. In this way, safety may be enhanced by, for example, having the pilot focus on operating the aircraft, and the other crewmember can focus on other tasks, including, for example, operating weapon or reconnaissance systems or acting as mission commander. The system can be configured to use various methods to identify individual crewmembers, thereby allowing for user-associated profiles to provide tailored display configurations, including choices of graphical elements, positions, and angles.

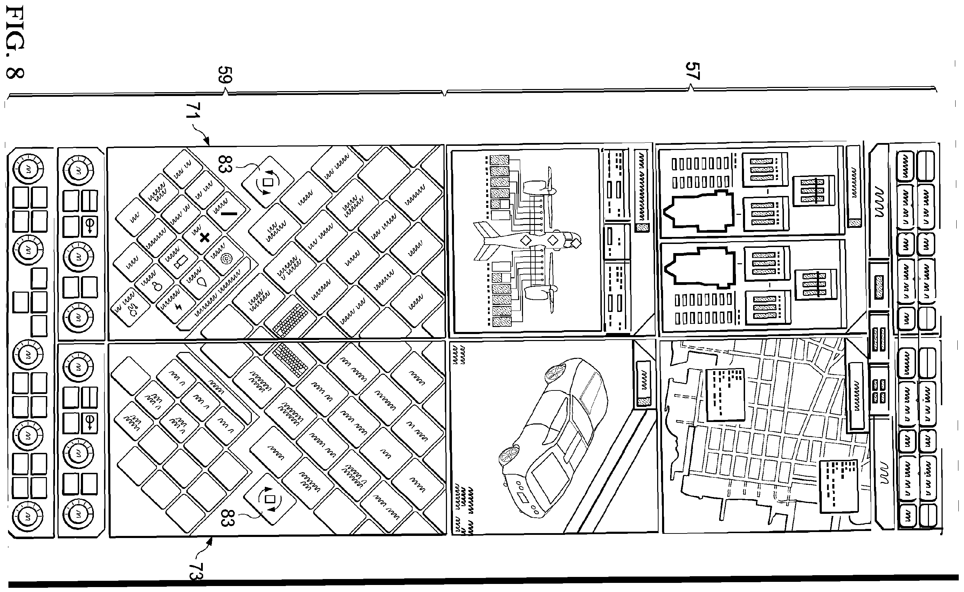

Figures 8 through 12 illustrate additional embodiments of a graphical display mode for use with interfaces 51, 53. In these figures, panel display 57 is configured as described above for Figure 7, and pedestal display 59 comprises one or more virtual input devices rotated to a user-selectable angle using a virtual rotate button 83. The amount of rotation may be a preselected angle, or the amount of rotation may correspond to detected motion of an object, such as a finger of a crewmember or a stylus, on or near display 59. In addition to rotation, the use of touchscreens allows for pinch and zoom motions to alter the graphical representations depicted on display 59, and display 59 may provide the ability to use a motion to slide graphical elements to preferred positions or for the use of the other crewmember.

Due to space limitations encountered due to rotation, virtual keys will preferably be prioritized as needed to populate the available space, with secondary keys moving to an off-screen page. It is preferred that main keys will remain on the screen and may stay in a selected orientation despite being rotated.

Figure 8 illustrates another embodiment of a graphical display mode for use with interfaces 51, 53. In this display mode, both sections 71, 73 have graphical representation of virtual input devices, similar to those shown in Figure 7, but the virtual input devices are rotated 45 degrees relative to the centerline of aircraft 11. This rotated representation allows each crewmember to view and interact with the virtual input devices on the crewmember's respective section 71, 73 with reduced need to rotate or bend the torso.

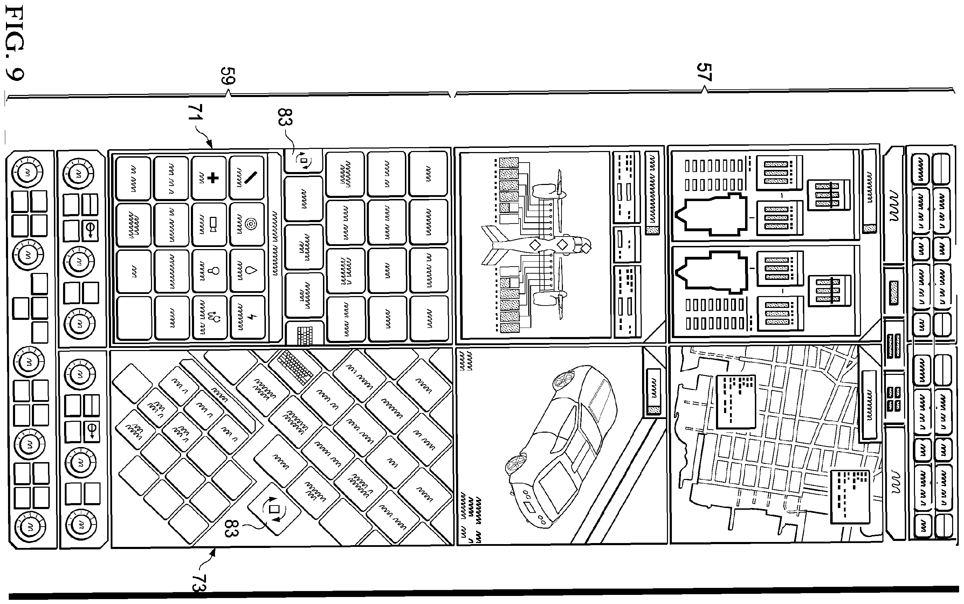

Figure 9 illustrates another embodiment of a graphical display mode for use with interfaces 51, 53. In this display mode, the virtual input devices of section 71 are not rotated relative to the aircraft centerline, whereas those of section 73 are rotated 45 degrees. This figure highlights the differing virtual-key location configuration necessary when the virtual input device is rotated.

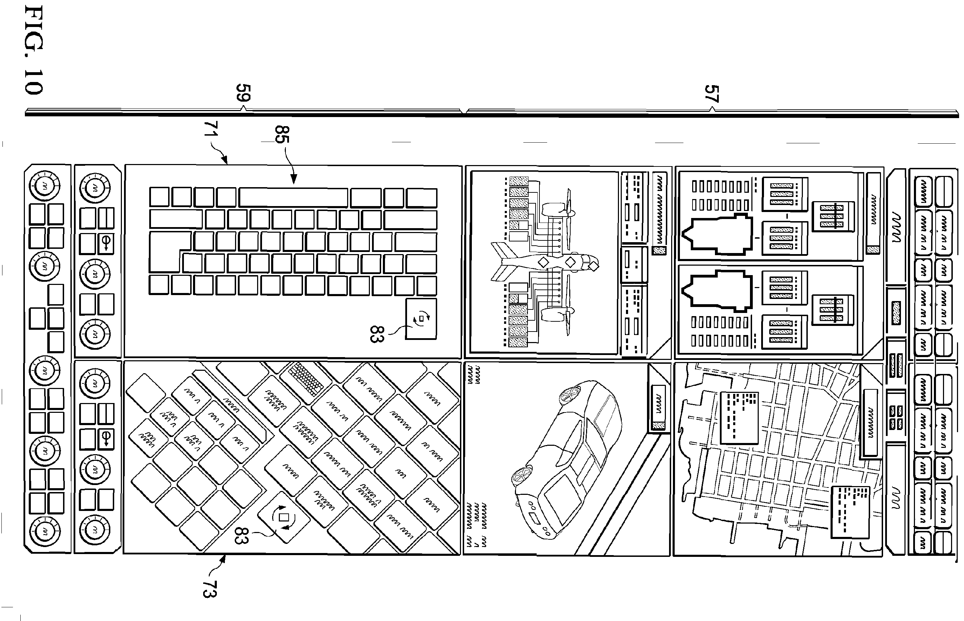

Figure 10 illustrates another embodiment of a graphical display mode for use with interfaces 51, 53. In this display mode, the virtual input devices of section 73 are rotated 45 degrees, and a graphical representation of a full keyboard, such as QWERTY keyboard 85, is presented in section 71. Keyboard 85 is shown rotated 90 degrees relative to the aircraft centerline, which allows keyboard 85 to appear as large as possible when presented on one of sections 71, 73.

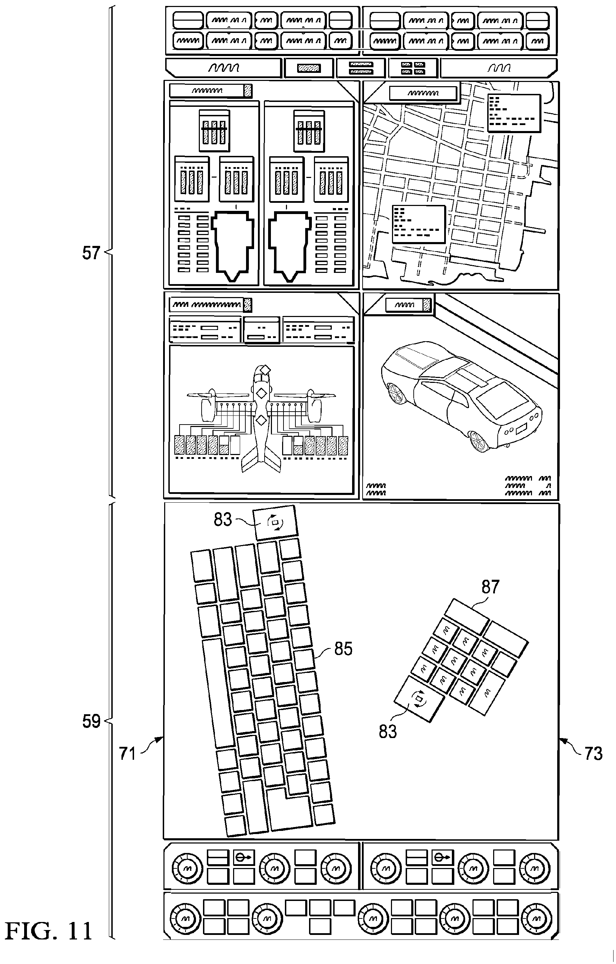

Figure 11 illustrates another embodiment of a graphical display mode for use with interfaces 51, 53. QWERTY keyboard 85 is displayed in section 71 at an angle less than 45 degrees, and a number pad 87 is displayed in section 73 rotated at approximately 45 degrees.

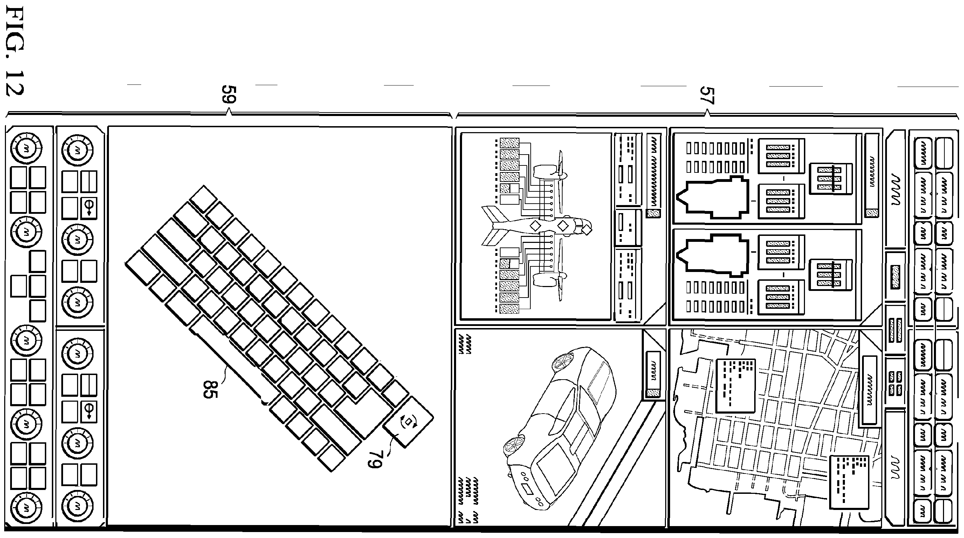

Figure 12 illustrates another embodiment of a graphical display mode for use with interfaces 51, 53. Virtual input devices, like QWERTY keyboard 85, can be displayed across both sections 71, 73, providing for the largest possible size for the input device. As shown in the figure, QWERTY keyboard 85 is expanded to a large enough size that keyboard 85 extends into both sections 71, 73.

In addition to rotation, virtual interface elements, such as keyboard 85, number pad 87, arrays of virtual keys 79, individual virtual keys 79, virtual knobs, and other graphical representations may be moved in translation within sections 71, 73 of interface 53 or may be moved to or from another display, such as interface 51. The system will comprise instructions for detecting movement of an object, such as a finger of a crewmember or a stylus, on or near the location of a virtual interface element displayed on interface 53 and display the selected amount of translation of the selected element that corresponds to the motion of the object.

Electronic components of both panel 47 and pedestal 49 are in electronic communication with at least one general purpose processor system carried onboard aircraft 11. Figure 13 illustrates a typical, general-purpose processor (e.g., electronic controller or computer) system 300 that includes a processing component 310 suitable for implementing one or more embodiments disclosed herein. In particular, one or more of the above-described electronic touchscreen displays may comprise one or more systems 300. In addition to the processor 310 (which may be referred to as a central processor unit or CPU), the system 300 might include network connectivity devices 320, random access memory (RAM) 330, read only memory (ROM) 340, secondary storage 350, and input/output (I/O) devices 360. In some cases, some of these components may not be present or may be combined in various combinations with one another or with other components not shown. These components might be located in a single physical entity or in more than one physical entity. Any actions described herein as being taken by the processor 310 might be taken by the processor 310 alone or by the processor 310 in conjunction with one or more components shown or not shown in the drawing. It will be appreciated that the data described herein can be stored in memory and/or in one or more databases.

The processor 310 executes instructions, codes, computer programs, or scripts that it might access from the network connectivity devices 320, RAM 330, ROM 340, or secondary storage 350 (which might include various disk-based systems such as hard disk, floppy disk, optical disk, or other drive). While only one processor 310 is shown, multiple processors may be present. Thus, while instructions may be discussed as being executed by a processor, the instructions may be executed simultaneously, serially, or otherwise by one or multiple processors. The processor 310 may be implemented as one or more CPU chips.

The network connectivity devices 320 may take the form of modems, modem banks, Ethernet devices, universal serial bus (USB) interface devices, serial interfaces, token ring devices, fiber distributed data interface (FDDI) devices, wireless local area network (WLAN) devices, radio transceiver devices such as code division multiple access (CDMA) devices, global system for mobile communications (GSM) radio transceiver devices, worldwide interoperability for microwave access (WiMAX) devices, and/or other well-known devices for connecting to networks. These network connectivity devices 320 may enable the processor 310 to communicate with the Internet or one or more telecommunications networks or other networks from which the processor 310 might receive information or to which the processor 310 might output information.

The network connectivity devices 320 might also include one or more transceiver components 325 capable of transmitting and/or receiving data wirelessly in the form of electromagnetic waves, such as radio frequency signals or microwave frequency signals. Alternatively, the data may propagate in or on the surface of electrical conductors, in coaxial cables, in waveguides, in optical media such as optical fiber, or in other media. The transceiver component 325 might include separate receiving and transmitting units or a single transceiver. Information transmitted or received by the transceiver 325 may include data that has been processed by the processor 310 or instructions that are to be executed by processor 310. Such information may be received from and outputted to a network in the form, for example, of a computer data baseband signal or signal embodied in a carrier wave. The data may be ordered according to different sequences as may be desirable for either processing or generating the data or transmitting or receiving the data. The baseband signal, the signal embedded in the carrier wave, or other types of signals currently used or hereafter developed may be referred to as the transmission medium and may be generated according to several methods well known to one skilled in the art.

The RAM 330 might be used to store volatile data and perhaps to store instructions that are executed by the processor 310. The ROM 340 is a non-volatile memory device that typically has a smaller memory capacity than the memory capacity of the secondary storage 350. ROM 340 might be used to store instructions and perhaps data that are read during execution of the instructions. Access to both RAM 330 and ROM 340 is typically faster than to secondary storage 350. The secondary storage 350 is typically comprised of one or more disk drives or tape drives and might be used for non-volatile storage of data or as an over-flow data storage device if RAM 330 is not large enough to hold all working data. Secondary storage 350 may be used to store programs or instructions that are loaded into RAM 330 when such programs are selected for execution or information is needed.

The I/O devices 360 may include liquid crystal displays (LCDs), touchscreen displays, keyboards, keypads, switches, dials, mice, track balls, voice recognizers, card readers, paper tape readers, printers, video monitors, transducers, sensors, or other well-known input or output devices. Also, the transceiver 325 might be considered to be a component of the I/O devices 360 instead of or in addition to being a component of the network connectivity devices 320. Some or all of the I/O devices 360 may be substantially similar to various components disclosed herein.

While the embodiments are shown and described in use with an aircraft, the apparatus, systems, and methods of this disclosure are equally applicable to other vehicle types, including those found in automotive and marine applications.

## Claims

1. An aircraft system interface, comprising:
a center pedestal (49);
a first touchscreen display (53) carried by the center pedestal (49);
one or more processors (310);
memory (330, 340, 350); and
one or more programs, wherein the one or more programs are stored in the memory (330, 340, 350) and configured to be executed by the one or more processors (310), the programs including:
instructions for displaying a virtual input device on the first touchscreen display (51);
instructions for displaying a rotate button (83) on the first touchscreen display (53);
instructions for detecting a movement of an object on or near the first touchscreen display (51); and
instructions for rotating the virtual input device displayed on the first touchscreen display (51) by a preselected amount in response to detecting the movement of the object on or near the rotate button.

2. An aircraft (11), comprising:
a cockpit (13);
an aircraft system interface according to claim 1.

3. The aircraft system interface of claim 1 or the aircraft of claim 2, wherein the virtual input device is a keyboard (85).

4. The aircraft system interface of claim 1 or the aircraft of claim 2, wherein the virtual input device is a number pad (87).

5. The aircraft system interface of claim 1 or the aircraft of claim 2, wherein the virtual input device is an array of virtual keys (79).

6. The aircraft system interface of claim 1 or of any of claims 3 to 5, the programs further comprising:
instructions for displaying different virtual input devices on adjacent sections (71, 73) of the first touchscreen display (53).

7. The aircraft system interface of claim 1 or of any of claims 3 to 6, the programs further comprising:
instructions for displaying different virtual input devices on adjacent sections (71,73) of the first touchscreen display (53); and
instructions for displaying a rotate button (83) on the first touchscreen display (53) for each virtual input device, movement of the object on or near one of the rotate buttons (83) causing a rotation of at least one of the virtual input devices;
wherein each virtual input device can be individually rotated to a selected angle.

8. The aircraft system interface of claim 1 or any of claims 3 to 7, the programs further comprising:
instructions for displaying a virtual input device across adjacent sections (71, 73) of the first touchscreen display (53).

9. The aircraft system interface of claim 1 or any of claims 3 to 8, the programs further comprising:
instructions for allowing movement of the object on or near the virtual input device to cause translation motion of the virtual input device on the first touchscreen display (53).

10. The aircraft system interface of claim 1 or of any of claims 3 to 9, or the aircraft of claim 2 or of any of claims 3 to 5, further comprising:
a second touchscreen display (51);
instructions for allowing movement of the object on or near the virtual input device to cause translation motion of the virtual input device between the first touchscreen display (53) and the second touchscreen display (51).

11. A method of displaying a virtual input device in an aircraft; the method comprising:
(a) displaying a virtual input device on a touchscreen display (53) on a center pedestal (49) in a cockpit (13);
(b) displaying a virtual rotate button (83) on the touchscreen display (53); and
(c) rotating the virtual input device a preselected amount in response to movement of an object on or near the virtual rotate button (83).

## Patentansprüche

1. Flugzeugsystemschnittstelle, umfassend:
ein zentrales Podest (49);
eine durch das zentrale Podest (49) getragene erste Berührungsbildschirmanzeige (53);
einen oder mehrere Prozessoren (310);
Speicher (330, 340, 350); und
ein oder mehrere Programme, wobei das eine oder die mehreren Programme in dem Speicher (330, 340, 350) gespeichert sind und dafür eingerichtet sind, durch den einen oder die mehreren Prozessoren (310) ausgeführt zu werden, wobei die Programme einschließen:
Anweisungen zum Anzeigen einer virtuellen Eingabeeinrichtung auf der ersten Berührungsbildschirmanzeige (51);
Anweisungen zum Anzeigen eines Rotierknopfs (83) auf der ersten Berührungsbildschirmanzeige (53);
Anweisungen zum Erfassen einer Bewegung eines Objekts auf oder nahe der ersten Berührungsbildschirmanzeige (51); und
Anweisungen zum Rotieren der auf der ersten Berührungsbildschirmanzeige (51) angezeigten virtuellen Eingabeeinrichtung um einen vorausgewählten Betrag in Antwort auf Erfassen der Bewegung des Objekts auf oder nahe dem Rotierknopf.

2. Flugzeug (11), umfassend:
ein Cockpit (13);
eine Flugzeugsystemschnittstelle nach Anspruch 1.

3. Flugzeugsystemschnittstelle nach Anspruch 1 oder Flugzeug nach Anspruch 2, wobei die virtuelle Eingabeeinrichtung eine Tastatur (85) ist.

4. Flugzeugsystemschnittstelle nach Anspruch 1 oder Flugzeug nach Anspruch 2, wobei die virtuelle Eingabeeinrichtung ein Ziffernfeld (87) ist.

5. Flugzeugsystemschnittstelle nach Anspruch 1 oder Flugzeug nach Anspruch 2, wobei die virtuelle Eingabeeinrichtung eine Anordnung von virtuellen Tasten (79) ist.

6. Flugzeugsystemschnittstelle nach Anspruch 1 oder nach einem der Ansprüche 3 bis 5, die Programme weiter umfassend:
Anweisungen zum Anzeigen von unterschiedlichen virtuellen Eingabeeinrichtungen auf benachbarten Abschnitten (71, 73) der ersten Berührungsbildschirmanzeige (53).

7. Flugzeugsystemschnittstelle nach Anspruch 1 oder nach einem der Ansprüche 3 bis 6, die Programme weiter umfassend:
Anweisungen zum Anzeigen von unterschiedlichen virtuellen Eingabeeinrichtungen auf benachbarten Abschnitten (71, 73) der ersten Berührungsbildschirmanzeige (53); und
Anweisungen zum Anzeigen eines Rotierknopfs (83) auf der ersten Berührungsbildschirmanzeige (53) für jede virtuelle Eingabeeinrichtung, wobei Bewegung des Objekts auf oder nahe einem der Rotierknöpfe (83) eine Rotation von mindestens einer der virtuellen Eingabeeinrichtungen veranlasst;
wobei jede virtuelle Eingabeeinrichtung individuell auf einen ausgewählten Winkel rotiert werden kann.

8. Flugzeugsystemschnittstelle nach Anspruch 1 oder nach einem der Ansprüche 3 bis 7, die Programme weiter umfassend:
Anweisungen zum Anzeigen einer virtuellen Eingabeeinrichtung über benachbarte Abschnitte (71, 73) der ersten Berührungsbildschirmanzeige (53) hinweg.

9. Flugzeugsystemschnittstelle nach Anspruch 1 oder nach einem der Ansprüche 3 bis 8, die Programme weiter umfassend:
Anweisungen, um Bewegung des Objekts auf oder nahe der virtuellen Eingabeeinrichtung zu erlauben, Translationsbewegung der virtuellen Eingabeeinrichtung auf der ersten Berührungsbildschirmanzeige (53) zu veranlassen.

10. Flugzeugsystemschnittstelle nach Anspruch 1 oder nach einem der Ansprüche 3 bis 9 oder Flugzeug nach Anspruch 2 oder nach einem der Ansprüche 3 bis 5, weiter umfassend:
eine zweite Berührungsbildschirmanzeige (51);
Anweisungen, um Bewegung des Objekts auf oder nahe der virtuellen Eingabeeinrichtung zu erlauben, Translationsbewegung der virtuellen Eingabeeinrichtung zwischen der ersten Berührungsbildschirmanzeige (53) und der zweiten Berührungsbildschirmanzeige (51) zu veranlassen.

11. Verfahren eines Anzeigens einer virtuellen Eingabeeinrichtung in einem Flugzeug; das Verfahren umfassend:
(a) Anzeigen einer virtuellen Eingabeeinrichtung auf einer Berührungsbildschirmanzeige (53) auf einem zentralen Podest (49) in einem Cockpit (13);
(b) Anzeigen eines virtuellen Rotierknopfs (83) auf der Berührungsbildschirmanzeige (53); und
(c) Rotieren der virtuellen Eingabeeinrichtung um einen vorausgewählten Betrag in Antwort auf Bewegung eines Objekts auf oder nahe dem virtuellen Rotierknopf (83).

## Revendications

1. Interface de système d'aéronef, comprenant :
un socle central (49) ;
un premier écran tactile (53) supporté par le socle central (49) ;
un ou plusieurs processeurs (310) ;
une mémoire (330, 340, 350) ; et
un ou plusieurs programmes, dans laquelle les un ou plusieurs programmes sont stockés dans la mémoire (330, 340, 350) et configurés pour être exécutés par les un ou plusieurs processeurs (310), les programmes incluant :
des instructions pour afficher un dispositif d'entrée virtuel sur le premier écran tactile (51) ;
des instructions pour afficher un bouton de rotation (83) sur le premier écran tactile (53) ;
des instructions pour détecter un déplacement d'un objet sur ou près du premier écran tactile (51) ; et
des instructions pour soumettre le dispositif d'entrée virtuel affiché sur le premier écran tactile (51) à une rotation d'une quantité présélectionnée en réponse à la détection du déplacement de l'objet sur ou près du bouton de rotation.

2. Aéronef (11), comprenant :
un poste de pilotage (13) ;
une interface de système d'aéronef selon la revendication 1.

3. Interface de système d'aéronef selon la revendication 1 ou aéronef selon la revendication 2, dans lequel le dispositif d'entrée virtuel est un clavier (85).

4. Interface de système d'aéronef selon la revendication 1 ou aéronef selon la revendication 2, dans lequel le dispositif d'entrée virtuel est un pavé numérique (87).

5. Interface de système d'aéronef selon la revendication 1 ou aéronef selon la revendication 2, dans lequel le dispositif d'entrée virtuel est un ensemble de touches virtuelles (79).

6. Interface de système d'aéronef selon la revendication 1 ou selon l'une quelconque des revendications 3 à 5, les programmes comprenant en outre :
des instructions pour afficher différents dispositifs d'entrée virtuels sur des sections adjacentes (71, 73) du premier écran tactile (53).

7. Interface de système d'aéronef selon la revendication 1 ou selon l'une quelconque des revendications 3 à 6, les programmes comprenant en outre :
des instructions pour afficher différents dispositifs d'entrée virtuels sur des sections adjacentes (71, 73) du premier écran tactile (53) ; et
des instructions pour afficher un bouton de rotation (83) sur le premier écran tactile (53) pour chaque dispositif d'entrée virtuel, un déplacement de l'objet sur ou près d'un des boutons de rotation (83) provoquant une rotation d'au moins un des dispositifs d'entrée virtuels ;
dans laquelle chaque dispositif d'entrée virtuel peut être individuellement soumis à une rotation selon un angle sélectionné.

8. Interface de système d'aéronef selon la revendication 1 ou selon l'une quelconque des revendications 3 à 7, les programmes comprenant en outre :
des instructions pour afficher un dispositif d'entrée virtuel dans des sections adjacentes (71, 73) du premier écran tactile (53).

9. Interface de système d'aéronef selon la revendication 1 ou selon l'une quelconque des revendications 3 à 8, les programmes comprenant en outre :
des instructions pour permettre un déplacement de l'objet sur ou près du dispositif d'entrée virtuel pour provoquer un mouvement de translation du dispositif d'entrée virtuel sur le premier écran tactile (53).

10. Interface de système d'aéronef selon la revendication 1 ou selon l'une quelconque des revendications 3 à 9, ou aéronef selon la revendication 2 ou selon l'une quelconque des revendications 3 à 5, comprenant en outre :
un second écran tactile (51) ;
des instructions pour permettre un déplacement de l'objet sur ou près du dispositif d'entrée virtuel pour provoquer un mouvement de translation du dispositif d'entrée virtuel entre le premier écran tactile (53) et le second écran tactile (51).

11. Procédé d'affichage d'un dispositif d'entrée virtuel dans un aéronef; le procédé comprenant :
(a) l'affichage d'un dispositif d'entrée virtuel sur un écran tactile (53) sur un socle central (49) dans un poste de pilotage (13) ;
(b) l'affichage d'un bouton de rotation virtuel (83) sur l'écran tactile (53) ; et
(c) la rotation du dispositif d'entrée virtuel d'une quantité présélectionnée en réponse à un déplacement d'un objet sur ou près du bouton de rotation virtuel (83).
